# EUROPÄISCHE PATENTSCHRIFT

(11) **EP 2 114 113 B1**
(45) Veröffentlichungstag und Bekanntmachung des Hinweises auf die Patenterteilung: **28.05.2014**
(21) Anmeldenummer: 08008203.5
(22) Anmeldetag: 29.04.2008
(51) Int. Cl.: H01L 23/40, H01L 23/473, H05K 1/14, H05K 3/00, H05K 7/20, H05K 1/02

(54) **Leiterplatteneinheit und Verfahren zu deren Herstellung**
Printed Circuit Board and corresponding production method
Unité de circuits imprimés et procédé de fabrication correspondant

(43) Veröffentlichungstag der Anmeldung: 04.11.2009
(73) Patentinhaber: Agie Charmilles SA, 6616 Losone (CH)
(72) Erfinder: Bühler, Ernst, 6616 Losone (CH); Knaak, Reto, 6612 Ascona (CH); D'Amario, Rino, 6806 Sigirino (CH); Lombardo, Rosario, 28822 Cannobio (IT)
(74) Vertreter: De Colle, Piergiacomo

(56) Entgegenhaltungen:
- EP-A- 0 590 354
- EP-A- 1 638 384
- EP-A- 1 830 406
- WO-A-99/52148
- GB-A- 2 163 598
- US-A- 5 466 970

## Beschreibung

### GEBIET DER ERFINDUNG

Die Erfindung betrifft eine Leiterplatteneinheit und ein Verfahren zu deren Herstellung, bspw. für leistungselektronische Anwendungen.

### HINTERGRUND DER ERFINDUNG

Immer häufiger werden beispielsweise leistungselektronische Lösungen für Aufgaben verlangt, welche früher, wenn überhaupt, mit mechanischen oder elektromechanischen Mitteln gelöst wurden. Die ständig steigenden Arbeits- und Materialkosten, sowie Volumen und Gewicht der elektronischen Baugruppen sind dabei zum Haupthindernis für innovative Lösungen geworden. Die kostenintensivsten Anteile sind meistens die manuelle Bestückung von Baugruppen, die eine starke Wärmeleistung produzieren, wie z.B. Leistungshalbleiter, sowie deren Montage auf Kühleinrichtungen zur Wärmeabfuhr der entstehenden Wärmeleistung. Die Zuverlässigkeit einer Baugruppe ist gegenwärtig insbesondere durch die Qualität dieser manuellen Arbeitsabläufe bestimmt. Die Qualitätssicherung wird dadurch wesentlich verteuert.

Die Herstellung, Prüfung, der Betrieb und die Wartung derartiger elektronischer Baugruppen muss im internationalen Umfeld erfolgreich bestehen können. Dazu sind geringe Material- und Herstellkosten erforderlich, aber es müssen auch Reparaturen, Modifikationen und zuletzt eine umweltgerechte Entsorgung garantiert werden können. Die Fertigungsprozesse müssen bedeutend zuverlässiger werden, um die Herstellkosten zu senken. Weiter ist es vorteilhaft, wenn gleiche oder ähnliche Module für Hochpreis- und Billigprodukte eingesetzt werden können.

Eine völlig neue Herausforderung hat sich beim Bau von Werkzeugmaschinen ergeben, wo man die Elektronikschränke durch Module ersetzen möchte, welche dann direkt in die Maschine einzubauen wären. Da Werkzeugmaschinen auf Abwärme mit Dehnungen und Verwindungen reagieren, muss der Wärmeabfuhr besondere Aufmerksamkeit geschenkt werden.

Im Falle von Funkenerosionsmaschinen ist die Lage besonders schwierig, da auch Impulsgeneratoren mit einer Abwärme im Kilowattbereich einzubauen sind.

### STAND DER TECHNIK

Für die Antriebstechnik und verwandte Gebiete werden seit langer Zeit Module angeboten. Es handelt sich meist um ein- bis dreiphasige Brückenschaltungen von Dioden-, IGBT- oder MOSFET- Bauelementen in Chipform, welche auf ein spezielles Kupfer-Keramiksubstrat aufgelötet und mit Bonddrähten kontaktiert sind. Es wäre denkbar, Spezialausführungen solcher Module mit einer Kühleinrichtung zu versehen und zusammen mit der Steuerelektronik in ein Gehäuse zu verpacken.

Nachteilig bei dieser Lösung ist, dass der Integrationsgrad der Module viel zu gering ist, um komplexere Schaltungen zu realisieren, und dass ein Teilausfall in einem Modul nicht repariert werden kann. Viele qualitätskritische, manuelle Fertigungsprozesse, wie das Aufbringen von Wärmeleitpaste oder heikle Schraubverbindungen bleiben bei dieser Lösung bestehen. Die Verlustwärme der Steuerelektronik kann auch erheblich sein - dieses Problem ist ebenfalls nicht gelöst.

Für Großserien in der Autoindustrie und in der Antriebstechnik werden immer häufiger komplexe leistungselektronische Module in SMD-Technologie (Surface Mount Device) eingesetzt, wobei die SMD-Komponenten einseitig auf eine Leiterplatte aufgebracht werden. Die Unterseite der Leiterplatte ist für die Wärmeabfuhr meistens mit einer metallischen Grundplatte verklebt. Eine solche Lösung ist in der EP 0 590 354 B1 offenbart und in Fig. 3 als Stand der Technik dargestellt. Das Modul wird über die Grundplatte an ein Kühlsystem angeschlossen. Meistens werden spezielle, dünne Isolationslagen mit erhöhter Wärmeleitfähigkeit verwendet, um die Leistungselemente besser zu kühlen.

Module dieser Art stellen einen Fortschritt dar, haben aber die Nachteile, dass sie einerseits für höhere Verlustleistungen noch ungenügend kühlen und anderseits fast nicht reparierbar sind, weil bei Reparaturprozessen die massive Grundplatte eine derart hohe Wärmesenke darstellt, dass man die Löttemperatur von bleifreien Loten kaum erreichen kann, ohne die ganze Schaltung zu schädigen. Um die wärmeleitende Isolationslage effektiv zu gestalten, wird diese in geringster Dicke gefertigt, was leider zu nachteilig hohen elektrischen Streukapazitäten führt und für höhere Spannungen und Frequenzen sehr ungünstig ist.

Eine Variante dieser Lösung sieht zwei Leiterplatten vor, welche mit einem Kern von etwa 1 mm bis 5mm Aluminium oder Kupfer verklebt sind, und auch mit isolierten Kontaktierungen zwischen den zwei Leiterplatten versehen werden können. Die aufgeführten Hauptnachteile bleiben bestehen, zusätzlich werden aber die Bauelemente gegen das Zentrum der Leiterplatte hin wegen der beschränkten lateralen Wärmeleitung der Kühlplatte erheblich schlechter gekühlt, da die Wärme nur über die Ränder der Leiterplatte abgeführt wird.

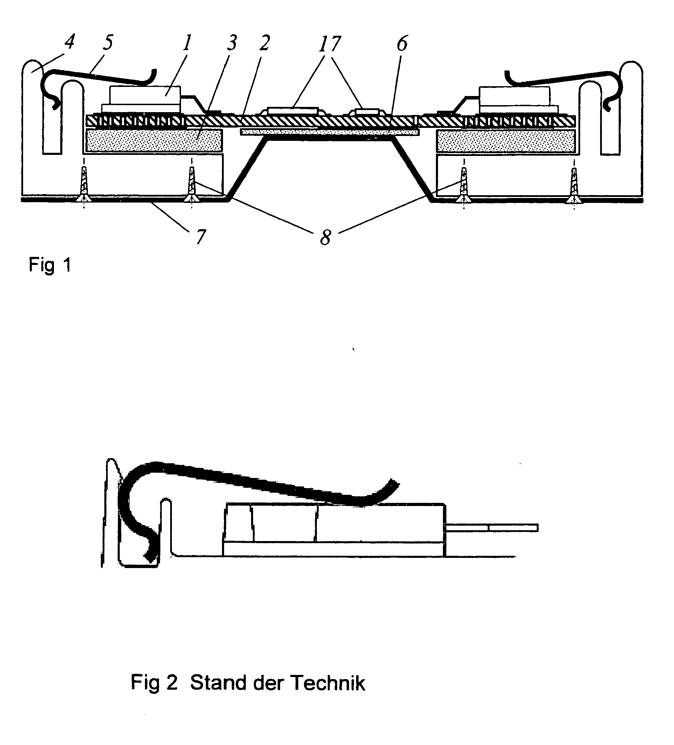

Die Fig. 2 zeigt einen typischen bekannten Aufbau der Firma AAVID THERMALLOY für eine bedrahtetes TO247-Leistungselement, welches mit einem metallischen Clip - ohne elektrische Isolation - auf ein Kühlkörperprofil gepresst wird. Durch die fehlende elektrische Isolation können ungünstige Potentialverteilungen entstehen.

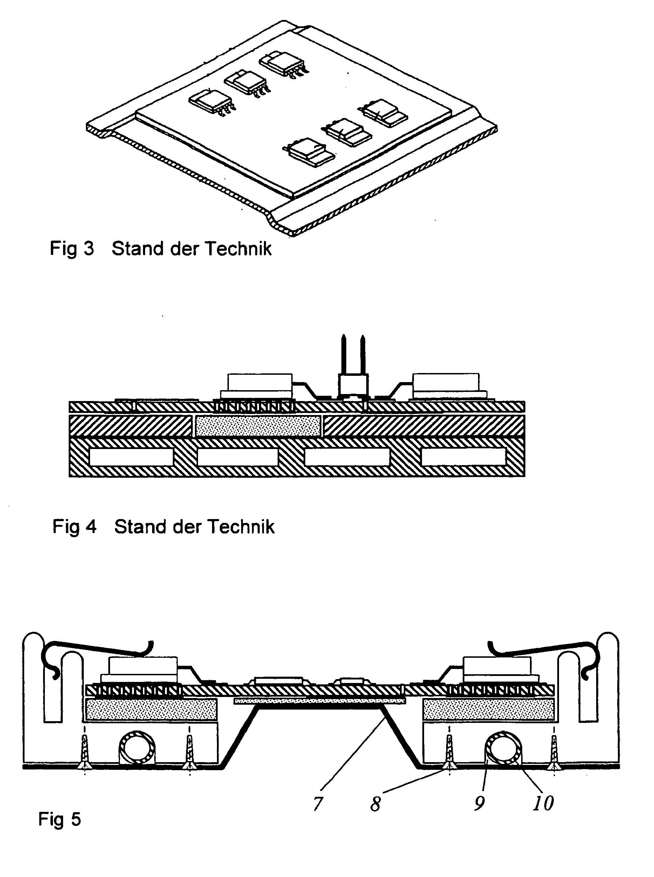

In der Patentanmeldung Nr. EP 06 02 2498 wird eine Leiterplatte mit direkt integriertem Flüssigkeitskühler offenbart, welche mit heute üblichen Fertigungsverfahren für Leiterplatten herstellbar ist. In der Leiterplatte sind Keramikeinlagen zur besseren Wärmeleitung unter SMD-Elementen mit hoher Wärmebelastung eingebettet. Fig. 4 zeigt diesen Aufbau als Stand der Technik.

Diese Lösung erfüllt die gestellten Anforderungen für die moderne GroßSerienfertigung, verlangt aber teils Fertigungsschritte, welche für technologisch weniger entwickelte Werkplätze zu einem ernsthaften Hindernis werden können. Als weiterer Nachteil dieser Patentanmeldung muss die Tatsache gesehen werden, dass eine Luftkühlung von Vornherein ausgeschlossen ist. Dies kann sich nachteilig auf die Herstellungskosten von Niedrigpreisprodukten auswirken. Ein weiteres Problem tritt bei einer Überlastung mit unzulässiger Temperaturexkursion von Leistungselementen auf. Solche Störfälle können zu einer Delaminierung der einzelnen Schichten der Leiterplatte und zur Blasenbildung führen und damit den Totalausfall des gesamten Moduls hervorrufen.

Aus der Europäischen Patentanmeldung EP 1 638 384 A1 ist ein Verfahren und eine Vorrichtung zum Kühlen von SMD-Leistungselementen bekannt, bei dem das Leistungselement direkt auf einem Wärmeleitungsplug aufgebracht ist. Der Wärmeleitungsplug befindet sich in einem Loch in einer Leiterplatine. Das Loch in der Platine zusammen mit dem Wärmeleitungsplug hat ungefähr die Ausdehnung des zu kühlenden Leistungselements. Der Wärmeleitungsplug ist ferner auf einer elektrischen Isolationsschicht angeordnet unter der sich ein Kühlkörper befindet. Ein Klemmbalken, der durch die Leiterplatine und die Isolationsschicht mit dem Kühlkörper verschraubt ist, klemmt das Leistungselement auf den Wärmeleitungsplug und damit auch auf den Kühlkörper.

### AUFGABE DER ERFINDUNG

Gegenüber dem Stand der Technik liegt der Erfindung die Aufgabe zugrunde, eine Leiterplatteneinheit und ein Verfahren zu deren Herstellung bereitzustellen, die eine ausreichende Wärmeabfuhr der Verlustwärme von oberflächenmontierbaren Bauelemente sicherstellen können. Bevorzugt soll dies mit einfachen Mitteln erreicht werden. Bevorzugt ist die Leiterplatteneinheit für Flüssigkeits- und Luftkühlung geeignet und für Hochpreisprodukte und Niedrigpreisprodukte anwendbar.

Eine weitere Aufgabe der Erfindung liegt darin, eine Leiterplatteneinheit und ein Verfahren zu deren Herstellung bereitzustellen, die es ermöglicht, leistungsstarke und/oder komplexe Systeme aufzubauen. Bevorzugt ist die Leiterplatteneinheit durch ihre Bauweise geeignet, die Elektronikbauteile vor den rauen Umweltbedingungen bei weltweitem Einsatz in Industrieumgebungen zu schützen. Ferner sollen dabei die Herstellung, der Betrieb, die Reparatur und die spätere Entsorgung der Leiterplatteneinheit den heutigen ökologischen und ökonomischen Grundsätzen besser genügen.

### KURZFASSUNG DER ERFINDUNG

Ein erster Aspekt der vorliegenden Erfindung betrifft ein Verfahren zur Herstellung einer Leiterplatteneinheit, bei dem: oberflächenmontierbare Bauelemente auf einer Leiterplatte automatisch platziert und gelötet werden, thermisch belastete oberflächenmontierbare Leistungselemente auf der Leiterplatte in Wärmeleitungsbereichen angeordnet werden, in denen metallische Durchkontaktierungen zur Wärmeleitung angeordnet werden, zwischen den oberflächenmontierbaren Leistungselementen und einem oder mehreren Kühlkörpern im Bereich der Durchkontaktierungen eine thermisch leitende und elektrisch isolierende Schicht angeordnet wird und die oberflächenmontierbaren Leistungselemente mit wenigstens einem elastischen Clip über die zwischenliegende Leiterplatte derart gegen den oder die mehreren Kühlkörper angepresst werden, dass die von den oberflächenmontierbaren Leistungselementen erzeugte Wärme über die Durchkontaktierungen zu den Kühlkörpern abgeleitet wird.

Ein zweiter Aspekt der vorliegenden Erfindung betrifft eine Leiterplatteneinheit, umfassend: eine Leiterplatte mit darauf gelöteten oberflächenmontierbaren Bauelementen, wenigstens ein auf der Leiterplatte in Wärmeleitungsbereichen angeordnetes thermisch belastetes oberflächenmontierbares Leistungselement, wobei die Wärmeleitungsbereiche metallische Durchkontaktierungen zur Wärmeleitung aufweisen, eine thermische leitenden und elektrische isolierende Schicht, die zwischen den oberflächenmontierbaren Leistungselementen und einem oder mehreren Kühlkörpern im Bereich der Durchkontaktierungen angeordnet ist, wobei die oberflächenmontierbaren Leistungselemente mit wenigstens einem elastischen Clip über die zwischenliegende Leiterplatte derart gegen den oder die mehreren Kühlkörper angepresst werden, dass die von den oberflächenmontierbaren Leistungselementen erzeugte Wärme über die Durchkontaktierungen zu den Kühlkörpern abgeleitet wird.

Weitere Aspekte und Merkmale der Erfindung ergeben sich aus den abhängigen Ansprüchen, der beigefügten Zeichnung und der nachfolgenden Beschreibung bevorzugter Ausführungsformen.

### KURZBESCHREIBUNG DER ZEICHNUNGEN

Nachfolgend werden unter Bezugnahme auf die beiliegenden Zeichnungen bevorzugte Ausführungsformen der Erfindung näher erläutert.

### Es zeigen:

- Fig. 1: Eine erste Ausführungsform eines Leistungsmoduls mit Luftkühlung.
- Fig. 2: Eine typische Clip Montage für bedrahtete Bauelemente nach dem Stand der Technik.
- Fig. 3: Ein bekanntes Verfahren zur Kühlung von SMD-Bauelementen nach dem Stand der Technik (EP 0 590 354 B1).
- Fig. 4: Ein bekanntes Verfahren zur Kühlung von SMD-Bauelementen nach dem Stand der Technik (Anmeldenummer EP 06 02 2498).
- Fig. 5: Eine zweite Ausführungsform eines Leistungsmoduls mit Flüssigkeits-und/oder Luftkühlung.
- Fig. 6: Eine weitere Ausführungsform mit Flüssigkeitskühlung, die stapelbar ist.
- Fig. 7: Eine weitere Ausführungsform, die ein System-Paket aus stapelbaren Leistungsmodulen nach Fig.6 darstellt.
- Fig. 8: Eine weitere stapelbare Ausführungsform eines Leistungsmoduls, das eine Leistungsplatte und eine Steuerplatte aufweist.
- Fig. 9: Eine weitere Ausführungsform, die ein System-Paket aus stapelbaren Leistungsmodulen nach Fig.8 darstellt.
- Fig. 10: Eine weitere Ausführungsform eines stapelbaren Leistungsmoduls mit Flüssigkeits- und/oder Luftkühlung.
- Fig. 11: Eine weitere Ausführungsform, die ein System-Paket aus stapelbaren Leistungsmodulen nach Fig. 10 darstellt.
- Fig. 12: Eine weitere stapelbare Ausführungsform mit Flüssigkeitskühlung und Clips für die Flüssigkeitskühlung aufweisend.
- Fig. 13: Eine weitere Ausführungsform, die ein System-Paket aus stapelbaren Leistungsmodulen nach Fig. 12 darstellt.
- Fig. 14: Eine weitere stapelbare Ausführungsform mit Kühlrippen, welche das elastische Einpressen von dünnwandigen Kühlrohren ermöglichen.
- Fig. 15: Eine weitere Ausführungsform, die ein System-Paket aus stapelbaren Leistungsmodulen mit teilweise eingesetzten Kühlrohren nach Fig. 14 darstellt.
- Fig. 16: Eine weitere stapelbare Ausführungsform mit einem verbesserten Wärmefluss.
- Fig. 17: Eine weitere Ausführungsform, die ein System-Paket aus Leistungsmodulen nach Fig. 16 darstellt, welche durch elastische Kühlrohre zusammengehalten werden.
- Fig. 18: Eine weitere Ausführungsform mit einem verbesserten Wärmefluss und modifizierter Ausformung für die Stapelung.
- Fig. 19: Eine weitere Ausführungsform, die ein System-Paket aus Leistungsmodulen nach Fig. 18 darstellt, wobei das letzte Modul kopfüber eingesetzt wird.
- Fig. 20: Eine weitere stapelbare Ausführungsform mit einer modifizierten Ausformung für die Stapelung.
- Fig. 21: Eine weitere Ausführungsform, die ein System-Paket aus Leistungsmodulen nach Fig. 20 darstellt, wobei das letzte Modul kopfüber eingesetzt wird.

### BESCHREIBUNG BEVORZUGTER AUSFÜHRUNGSFORMEN

In Fig. 1 ist eine erste Ausführungsform einer Leiterplatteneinheit (im Folgenden auch Leistungsmodul oder nur Modul genannt) in Übereinstimmung mit der vorliegenden Erfindung dargestellt, welche beispielsweise wenigstens teilweise aus handelsüblichen Komponenten hergestellt werden kann. Vor einer detaillierten Beschreibung der Ausführungsform von Fig. 1, folgen zunächst allgemeine Erläuterungen zu den Ausführungsformen der vorliegenden Erfindung und deren Vorteile.

Manche Ausführungsformen einer Leiterplatteneinheit in Übereinstimmung mit der vorliegenden Erfindung umfassen eine Leiterplatte (die bei manchen Ausführungsformen nicht durchgehend ist) und einen oder mehrere Kühlkörper (im Folgenden auch Kühl(körper)profil genannt). Auf der Leiterplatte sind oberflächenmontierbare Bauelemente, sogenannte SMD (Surface Mounted Device) Bauelemente, aufgelötet. Die SMD-Technik zeichnet sich dadurch aus, dass Bauelemente direkt auf eine Leiterplatte aufgelötet werden können. Bei manchen Ausführungsformen befinden sich insbesondere SMD-Bauelemente, die eine starke Wärmeleistung produzieren, in Wärmeleitungsbereichen der Leiterplatte. Derartige Bauelemente werden im Folgenden auch als (oberflächenmontierbare) Leistungselemente bezeichnet. Die Wärmeleitungsbereiche sind Bereiche mit erhöhter Wärmeleitfähigkeit, die bspw. dadurch erreicht wird, dass sich in den Wärmeleitungsbereichen metallisierte Durchgangsbohrungen befinden. Die Durchgangsbohrungen bilden metallische Durchkontaktierungen zur Wärmeleitung, die eine entsprechende Wärmeleitfähigkeit bereitstellen und daher Wärme von den Leistungselementen ableiten können. Folglich kann bspw. durch die Anzahl, die Form, die Größe des Durchmesser der Bohrungen, der Art des Materials bzw. der Metallisierung die Wärmeleitfähigkeit entsprechend verändert werden. Unter- und/oder oberhalb der Wärmeleitungsbereiche befindet sich eine thermisch leitende und elektrisch isolierende Schicht, bspw. eine Keramikisolation, die aus Aluminiumoxid oder Aluminiumnitrid hergestellt sein kann (Die Schicht ist bei manchen Ausführungsformen nicht direkt auf der Leiterplatte angeordnet, sondern es können sich auch andere Schichten dazwischen befinden. Die Schicht ist jedoch bei manchen Ausführungsformen wenigstens so (in der der Nähe der Wärmeleitungsbereiche) angeordnet, dass sie wenigstens einen Teil der durch bspw. das Leistungselement entstehenden Wärme zu dem Kühlkörper leitet.). Der Wärmeleitpfad ist folglich in manchen Ausführungsformen von dem Leistungselement durch die Durchkontaktierung zu der thermisch leitenden, aber elektrisch isolierenden Schicht (oder umgekehrt von dem Leistungselement durch die elektrisch isolierende Schicht zu den Durchkontaktierungen). Die thermisch leitende und elektrisch isolierende Schicht steht wiederum in Kontakt mit einem Kühlkörper (oder umgekehrt, steht die Durchkontaktierung in Kontakt mit dem Kühlkörper). Um nun den entsprechenden Wärmeleitungskontakt zwischen dem Leistungselement, den Durchkontaktierungen und der thermisch leitenden und elektrisch isolierenden Schicht herzustellen, presst ein elastischer Clip Bauelemente, wie bspw. SMD-Bauelemente und insbesondere SMD-Leistungselemente, derart gegen den oder die mehreren Kühlkörper, dass die von den Leistungselementen erzeugte Wärme über die Durchkontaktierungen zu dem(/n) Kühlkörper(n) abgeleitet wird. Der Anpressdruck durch den elastischen Clip ist dabei derart ausgebindet, dass er auch zusätzlich eine Haltefunktion erfüllen kann. Außerdem ist durch die Elastizität des Clips in manchen Ausführungsformen gewährleistet, dass - im Gegensatz zu bspw. Schraubverbindungen - der Anpressdruck nicht nach längerer Zeit, bspw. durch Materialermüdung, Erschütterungen und dergleichen, nachlässt.

Die Clips können aus jedem elastischen Material hergestellt werden und haben in manchen Ausführungsformen eine Form, bspw. eine S-artige Form, die die Elastizität und damit auch den Anpressdruck unterstützt. In manchen Ausführungsformen ist der Clip mit einem Ende, bspw. in einer Ausnehmung, in dem Kühlkörper befestigt. Das andere Ende des Clips drückt dann bspw. auf ein Leistungselement, so dass dieses auf den Wärmeleitungsbereich der Leiterplatte gepresst wird - d.h. ein Anpressdruck erzeugt wird - und zusammen mit dem Wärmeleitungsbereich auf die thermisch leitende und elektrisch isolierende Schicht gepresst wird (oder umgekehrt auf die elektrisch isolierende Schicht und dann auf die Leiterplatte), welche folglich auf eine Fläche des Kühlkörpers gepresst wird. Das eine Ende übt folglich an einem seiner Enden einen Anpressdruck auf das Leistungselement, den Wärmeleitungsbereich mit seinen Durchkontaktierungen der Leiterplatte, die thermisch leitende und elektrisch isolierende Schicht und schließlich auf eine Fläche des Kühlkörpers aus. Das andere Ende des Clips ruht dabei in manchen Ausführungsbeispielen in dem Aufnahmebereich des Kühlkörpers.

Der Aufnahmebereich des Kühlkörpers, der ein Ende des Clips aufnehmen kann, weist in manchen Ausführungsformen ein Oberflächenprofil auf einer Fläche auf, das geeignet ist, die Reibung zwischen einer seiner Oberflächen und bspw. einer Kante des Endes des Clips stark zu erhöhen. In manchen Ausführungsformen ist das Oberflächenprofil bspw. gezackt oder geriffelt ausgebildet, d.h. es weist Erhebungen und Vertiefungen auf, in die sich beispielsweise eine Kante des Endes des Clips wenigstens teilweise verhaken kann. In manchen Ausführungsformen weist eine Oberfläche des Aufnahmebereiches einen Vorsprung auf, der bspw. ein Ende des Clips davon abhält, aus dem Aufnahmebereich herauszurutschen. Bei manchen Ausführungsformen liegt beispielsweise ein gebogener Bereich des Clips an einer Oberfläche des Aufnahmebereichs an und folglich ist in manchen Ausführungsformen der gebogene Bereich mit einem Oberflächenprofil versehen, das geeignet ist, die Reibung zu erhöhen. Die Oberfläche des Aufnahmebereiches des Kühlkörpers weist bei manchen Ausführungsformen ein entsprechendes Profil auf, um die Reibung weiter zu verstärken und ein entsprechendes Herausgleiten des Clips aus dem Aufnahmebereich zu verhindern oder wenigstens zu erschweren.

Der Aufnahmebereich des Kühlkörpers befindet sich bei manchen Ausführungsformen seitlich der Leiterplatte und ist bspw. als Vertiefung in dem Kühlkörper ausgebildet. Der Kühlkörper geht folglich - im Querschnitt gesehen - L-artig um die Leiterplatte herum.

Bei manchen Ausführungsformen liegen die Wärmeleitungsbereiche mit den Durchkontaktierungen und die Leistungselemente, d.h. die Bauelemente mit hoher thermischer Last, in Randzonen bzw. Randbereichen der Leiterplatte. Der Clip, der bspw. in einem seitlichen Aufnahmebereich des Kühlkörpers sitzt oder dort verankert ist, erstreckt sich dann in diese Randbereich herein und übt - wie oben ausgeführt - den Anpressdruck auf das Leistungselement aus. In manchen Ausführungsformen befinden sich die Leistungselemente auch in der Mitte der Leiterplatte, so dass sich der Clip bis in diesen Mittenbereich erstreckt und dort den Anpressdruck ausübt.

Bei manchen Ausführungsformen ist der Clip so ausgebildet, dass er - bspw. als Dreibein - nicht nur Anpressdruck auf ein Bauelement, sondern auch auf zwei (oder mehr) Bauelemente ausüben kann.

Bei manchen Ausführungsformen leitet ein Kühlmedium, das bspw. gasförmig oder flüssig ist (bzw. ein Fluid), Wärme vom Kühlkörper ab. Dazu weist der Kühlkörper bspw. ein Profil auf, das bspw. die Oberfläche gegenüber einer Quaderform stark erhöht, wie bspw. Kühlrippen oder dergleichen. Bei manchen Ausführungsformen weist der Kühlkörper auch Kühlleitungen - wie bspw. dünnwandige, elastische Kühlrohre - auf, in denen eine Kühlflüssigkeit, wie bspw. Wasser, fließt und wodurch folglich die Wärme abgeleitet wird. Bei manchen Ausführungsformen sind die Kühlleitungen zwischen den Kühlrippen angeordnet. Folglich kann bei manchen Ausführungsformen die Kühlleistung einfach durch die Anzahl der Kühlleitungen, die Form der Kühlrippen und die entsprechende Kombination von Kühlleitungen und Kühlrippen sowie durch die Anzahl der Durchkontaktierungen im Wärmeleitungsbereich verändert werden.

Manche Ausführungsformen basieren bspw. auf der Nutzung der elastischen Verformung von Metallteilen. Es werden einerseits bekannte elastischen Clips für die Erzeugung eines Anpressdruckes zwischen einer Wärmequelle und einer Wärmesenke verwendet und andererseits dünnwandige, metallische Kühlrohre in Kanäle unter elastischer Deformation in den Kühlkörper eingepresst, um einen dauerhaft guten Wärmeübergang zu gewährleisten. Die Kühlrohre sind bei manchen Ausführungsformen beispielsweise aus Federstahl hergestellt.

Eine Delaminierung durch Störfälle mit Übertemperatur wird durch den elastischen Anpressdruck des elastischen Clips folglich bei manchen Ausführungsformen zumindest teilweise wirksam verhindert.

Bei manchen Ausführungsformen eines Verfahrens zur Herstellung einer Leitplatteneinheit können SMD-Bauelemente zuerst in einem Arbeitsgang maschinell auf die Leiterplatte montiert und gelötet werden. Leistungselemente mit hoher thermischer Last werden bei manchen Ausführungsformen bevorzugt in den Randzonen der Leiterplatte platziert. Unter und/oder über der Leiterplatte werden in diesen Randzonen eine thermisch gut leitende und elektrisch isolierende Schichten, wie bspw. Isolationselemente, angeordnet. Die Isolationselemente sind bei manchen Ausführungsformen aus Keramik wie Al₂O₃ (Aluminiumoxid) oder AIN (Aluminiumnitrid) hergestellt. Das Leistungselement, das auf dem Wärmeleitungsbereich der Leiterplatte angeordnet ist, wird bspw. mit einem Clip auf einen oder mehrere Kühlkörper, z.B. auf speziell geformte Kühl(körper)profile, gepresst.

Manche Ausführungsformen betreffen ein Verfahren zur Herstellung eines Moduls, bspw. einer Leiterplatteneinheit, für leistungselektronische Anwendungen in Werkzeugmaschinen mit einer integrierten Kühlung für oberflächenmontierte Bauelemente (SMD-Bauelemente) unter Verwendung von elastischen Clips zur Erzeugung einer Anpresskraft zwischen einer Wärmequelle und einer Kühleinrichtung, wobei die SMD-Bauelemente auf einer Leiterplatte automatisch platziert und gelötet werden und thermisch belastete SMD-Leistungselemente in Randzonen der Leiterplatte angeordnet werden. In der Leiterplatte werden in diesen Randzonen metallische Durchkontaktierungen zur Wärmeleitung angeordnet und zwischen diesen Randzonen und einem oder mehreren Kühlkörperprofilen wird eine thermisch leitende und elektrisch isolierende Schicht angeordnet. Die SMD-Leistungselemente werden mit elastischen Clips gegen das oder die Kühlkörperprofile gepresst, sodass die Wärme von dem oder den Kühlkörperprofilen über ein gasförmiges und/oder flüssiges Medium weggeführt wird.

Manche Ausführungsformen betreffen ein Leistungsmodul, wie eine Leiterplatteneinheit, für leistungselektronische Anwendungen in Werkzeugmaschinen mit einer integrierten Kühlung für oberflächenmontierte Bauelemente (SMD-Bauelemente) unter Verwendung von elastischen Clips zur Erzeugung einer Anpresskraft zwischen einer Wärmequelle und einer Kühleinrichtung, wobei die SMD-Bauelemente auf einer Leiterplatte automatisch platziert und gelötet sind. Thermisch belastete SMD-Leistungselemente sind in Randzonen der Leiterplatte angeordnet und die Leiterplatte weist in diesen Randzonen metallische Durchkontaktierungen zur Wärmeleitung auf. Zwischen diesen Randzonen und einem oder mehreren Kühlkörperprofilen ist eine thermisch leitende und elektrisch isolierende Schicht angeordnet und die SMD-Leistungselemente werden mit elastischen Clips derart gegen das oder die Kühlkörperprofile gepresst, dass der Wärmeabfluss von dem oder den Kühlkörperprofilen über ein gasförmiges und/oder flüssiges Medium vorgesehen werden kann.

Bei manchen Ausführungsformen kann durch einfaches Austauschen der Kühlprofile bzw. Kühlkörper oder durch zusätzliche Montage von Kühlrohren, zwischen Flüssigkeitskühlung und/oder Luftkühlung gewählt werden.

Bei manchen Ausführungsformen führt die kombinierte Flüssigkeits-/Luftkühlung zu einer neuartigen, erheblich robusteren Bauart, welche beim Totalausfall eines oder bei einem Teilausfall beider Kühlmedia den Betrieb aufrechterhalten kann.

Bei manchen Ausführungsformen wird der Innenraum eines Moduls bzw. einer Leiterplatteneinheit zum Schutz der Elektronikbauteile vor Umwelteinflüssen, vollständig mit Deckblechen verschlossen. Diese dienen bei manchen Ausführungsformen zusätzlich zur Kühlung und auch zur Verhinderung der Abstrahlung von elektromagnetischen Emissionen.

Manche Ausführungsformen eignen sich für den direkten Einbau in Werkzeugmaschinen und für ähnliche leistungselektronische Anwendungen, insbesondere aber für den direkten Einbau in Funkenerosionsmaschinen. Dank dem hohen Integrationsgrad und der effizienten Wärmeabfuhr können die Leistungsmodule so miniaturisiert werden, dass sie sich in einer beliebigen, optimalen Position in den Maschinen einbauen lassen. So werden zum Beispiel die Impulseigenschaften von Erosionsgeneratoren, dank der wegfallenden Hochfrequenz-Verkabelung, bedeutend verbessert. Die Leistungsmodule können ohne große Mehrkosten dicht gebaut werden, und ertragen so auch die rausten Umgebungsbedingungen. Zudem weisen die Module nur eine äußerst geringe Wärme- und elektromagnetische Abstrahlung auf - Eigenschaften, welche für einen Direkteinbau in eine Maschine vorteilhaft sind.

Ein weiterer Vorteil ergibt sich bei manchen Ausführungsformen durch die Aufteilung in eine Leiterplatte mit SMD-Leistungselementen und eine Leiterplatte mit SMD-Steuerelementen, weil bspw. dadurch die beiden Leiterplatten eine unterschiedliche Anzahl Leiterebenen und/oder unterschiedliche Leiterdicken aufweisen können. Dies ergibt erstens einen zusätzlichen Freiheitsgrad, um die Leiterplatten besser auf die Anwendung optimieren zu können, und zweitens können Treiber- und Steuersignale dank diesem Prinzip am richtigen Ort und auf kürzestem Weg zwischen der Steuerplatte und der Leistungsplatte über SMD- Steckverbinder verbunden werden. Da beliebig viele solcher Baueinheiten miteinander kombiniert werden können, sind auch System-Pakete mit sehr hoher Leistungsdicht möglich.

Manche Ausführungsformen ermöglichen die Anwendung von modernen automatischen Fertigungsmethoden für die Massenherstellung der Leistungsmodule bzw. Leiterplatteneinheiten, was zu einer namhaften Kostenreduktion und gleichzeitig zu einer hohen und reproduzierbaren Fertigungsqualität führt. Die Endmontage, Test und Wartung der Leistungsmodule kann im internationalen Umfeld und sogar in einfacheren Werkstätten erfolgen. Die SMT-Fertigungsmethode (SMT: Surface Mount Technology) basiert auf der automatischen Bestückung von unbedrahteten SMD-Bauelementen (SMD: Surface Mounted Devices) auf Leiterplatten, welche keine Bohrungen mehr für die Aufnahme von Drahtanschlüssen aufweisen.

Daraus ergibt sich bei manchen Ausführungsformen ein weiterer Vorteil am Ende der Produktlebensdauer. Zur Trennung von Elektronikschrott und mechanischen Teilen werden die elastischen Clips entfernt, dann werden die Leiterplatten entnommen und über den Schmelzpunkt des Lotes erwärmt, wodurch sich danach alle elektronischen Komponenten einfach abwischen lassen.

Manche Ausführungsformen der Erfindung betreffen einen modularen Aspekt. So ist bei manchen Ausführungsformen der Kühlkörper so ausgebildet, dass er positive und negative Ausformungen aufweist, die ineinandergreifen können. Diese Ausformungen können bspw. eine konvexe bzw. konkave Form haben. Diese positiven und negativen Ausformungen greifen bspw. ineinander, wenn die Leiterplatteneinheiten aufeinander gestapelt werden. Dadurch verbessert sich die Wärmeleitung von einer Leiterplatteneinheit zur anderen, sodass bspw. thermisch weniger belastete Leiterplatteneinheiten mit ihren Kühlkörpern und thermisch stärker belastete Leiterplatteneinheiten mit ihren Kühlkörpern untereinander Wärme austauschen können und sich so insgesamt die Kühlwirkung verbessert.

Durch die Ausformungen sind manche Ausführungsformen der Leiterplatteneinheit stapelbar und können dadurch bspw. ein System-Paket bilden. Dabei können mehrere Leistungsmodule bzw. Leiterplatteneinheiten durch einfaches Ineinanderschieben oder Einrasten der entsprechenden Ausformungen der Kühlkörper zu Systempaketen vereinigt werden.

Folglich realisieren manche Ausführungsformen ein Gesamtkonzept für den Aufbau und den Betrieb von Leistungsmodulen mit integrierter Kühlung.

Das Hauptanwendungsfeld mancher Ausführungsformen liegt im Maschinen- und Anlagenbau allgemein, ist aber vorteilhafterweise im Präzisions-Werkzeugmaschinenbau mit dessen stark variierenden Anforderungen zu sehen.

Zurückkehrend zu Fig. 1 werden dort SMD-Leistungselemente 1 und SMD-Steuerelemente 17 bei einer ersten Ausführungsform automatisch auf einer Leiterplatte 2 platziert und gelötet, wobei die thermisch belasteten SMD-Leistungselemente 1 in Randzonen der Leiterplatte 2 angeordnet werden, wo die Kühlkörperprofile 4 die Wärme abführen können.

In diesen Randzonen ist unter den SMD-Leistungselementen 1 eine Vielzahl von metallisierten Bohrungen für eine verbesserte Wärmeleitung angebracht. Zwischen diesen Randzonen der Leiterplatte 2 und dem Kühlkörperprofil 4 wird eine Keramikisolation 3 eingefügt, welche beidseitig eine Beschichtung mit einer Wärmeleitpaste aufweist. Man könnte anstelle der Keramikisolation 3 auch eine bekannte pulvergefüllte Polymerfolie verwenden, dies würde aber zu höheren Streukapazitäten und damit zu elektrischen Stör- Problemen führen.

Jedes Leistungselement 1 wird nun mit einem elastischen Clip 5, eine speziell geformte Blattfeder angepasster Stärke und Breite, über die Leiterplatte 2 und die Keramikisolation 3 gegen das Kühlkörperprofil 4 gepresst, und bekommt dadurch einen zuverlässigen Wärmekontakt mit dem Kühlkörperprofil 4.

Das Kühlkörperprofil 4 und der Clip 5 werden beispielsweise von der Firma AAVID THERMALLOY (www.aavidthermalloy.com) angeboten. Diese Firma offeriert neu auch Spezialausführungen von Kühlkörperprofilen 4 mit eingelöteten Edelstahlrohren für die Flüssigkeitskühlung von bedrahteten Leistungselementen.

Als Material für die Keramikisolation 3 eignet sich beispielsweise Aluminiumnitrid (AIN) mit einem thermischen Leitwert von 180W/mK besonders gut, aber auch das verbreitete und weit billigere Aluminiumoxyd (Al₂O₃) mit einem thermischen Leitwert von 24W/mK kann durchaus genügend sein. Berylliumoxyd (BeO) mit dem thermischen Leitwert von 260W/mK wäre zwar sehr interessant, kann aber wegen seiner hohen Giftigkeit in Staubform bei manchen Ausführungsformen nicht verwendet werden. Die elektrische Durchschlagsfestigkeit liegt für alle diese Keramikarten bei ausgezeichneten 10 bis 20 kV/mm, und ist für unsere Anforderungen mehr als ausreichend. Die relative Dielektrizitätskonstante ε_{R} zwischen 6.5 und 8.5 ist bei manchen Ausführungsformen eher ausschlaggebend für die Wahl des Materials und Dicke der Keramikisolation 3.

Materialien für die Keramikisolationen 3 bietet beispielsweise die Firma DENKA (www.denka.co.jp) an.

Versuche haben gezeigt, dass man mit dieser Ausführungsform bei einer Stärke der Leiterplatte 2 von 0.8mm und Aluminiumoxyd-Keramikisolationen 3 von 0.6mm Dicke, für eine SMD-Gehäuseform D2PAK eine maximale Verlustleistung von 30W und für eine SMD-Gehäuseform D3PAK eine maximale Verlustleistung von 50W unter realistischen Betriebsbedingungen abführen kann. Die entsprechenden Gehäuseformen für bedrahtete Bauelemente TO220 und TO247 erlauben kaum diese Werte. Dieser Fortschritt gestattet eine sehr kompakte Bauweise der Module.

Geringere Stärken der Leiterplatte 2 und Aluminiumnitrid-Keramikisolationen 3 lassen bei manchen Ausführungsformen noch höhere Verlustleistungen zu. Es gibt aber bestimmte Grenzen für die Belastbarkeit der SMD-Bauteile selbst, oberhalb jener die Zuverlässigkeit wegen den Temperaturzyklen generell abnimmt. In diesem Bereich kann eine Reduktion der Bauteiltemperatur um 10°C eine Verdoppelung der Lebensdauer bedeuten.

Die Kontaktflächen für die harten und spröden Keramikisolationen 3 müssen bei manchen Ausführungsformen absolut eben sein, d.h., dass die Leiterplatte 2 nach dem Lötprozess eventuell auf der Rückseite nachbearbeitet werden muss oder, dass ein ungenau extrudiertes Kühlkörperprofil 4 eventuell eine Nachbearbeitung braucht. Je nach Dicke der Leiterplatte 2 kann es auch bei manchen Ausführungsformen vorteilhaft sein, die Leiterplatte 2 zwischen SMD-Leistungselementen 1 mit Schlitzen oder Einkerbungen zu versehen, um ein planes Aufliegen auch bei einer leicht verbogenen Leiterplatte 2 zu garantieren.

Versuche haben gezeigt, dass sich alle Wärmeübergangswiderstände nach einer gewissen Betriebszeit generell reduzieren, was zu tieferen Temperaturen auf den SMD-Bauelementen führt. Um diesen vorteilhaften Zustand sofort zu erreichen und dies ohne Schäden an SMD-Bauelementen anzurichten, werden bei manchen Ausführungsformen die Module nach der Montage mit einer Wärmebehandlung stabilisiert.

Die thermisch weit weniger belasteten SMD-Steuerelemente 17, wie Prozessoren oder Logikschaltungen, können die Wärme ebenfalls abgeben: durch die Leiterplatte 2 hindurch über eine erste Wärmeleitfolie 6 und ein Bodenblech 7, welches mit Schrauben 8 mit den Kühlkörperprofilen 4 verbunden ist. Für diese SMD-Steuerelemente 17 ist der eher geringe thermische Leitwert von etwa 0.3W/mK der Leiterplatte 2 schon ausreichend für den Wärmetransport auf die Wärmeleitfolie 6.

Solche flexible Wärmeleitfolien 6 können beispielsweise aus einem Produkt GAP PAD A2000 von der Firma BERGQUIST (www.bergguistcompany.com) bestehen.

Fig. 5 zeigt eine Ausführungsform einer Weiterbildung der Ausführungsform nach Fig. 1, welche zusätzlich eine Flüssigkeitskühlung ermöglicht. Die Kühlkörperprofile 4 sind dazu mit einem U-förmigen Kanal 9 versehen, welcher geringfügig schmäler ist, als die dünnwandigen Kühlrohre 10 im Durchmesser sind. Das Bodenblech 7 drückt über Schrauben 8 die Kühlrohre 10 in die U-förmigen Kanäle 9. Dadurch werden die Kühlrohre 10 elastisch deformiert, und stehen darum in dauerhaftem, engem thermischen Kontakt mit den Kühlkörperprofilen 4.

Die Kühlrohre 10 wählt man je nach verwendeter Kühlflüssigkeit aus Kupfer, Aluminium, deren Legierungen oder Edelstahl. Die Werkstoffe müssen möglichst hart sein, um die erwünschte Federwirkung zu erzeugen. Die Werkstoffe sollen nicht etwa plastisch deformiert werden, denn bei Wärmeschrumpfungen würden sich plastische Deformationen irreversibel verhalten.

Die typische Wandstärke der Kühlrohre 10 beträgt bei dieser Ausführungsform etwa 0.2mm bis 1 mm. Die Kühlrohre 10 werden über Anschlussstücke (nicht gezeichnet) und/oder Schläuche (nicht gezeichnet) mit einem Kühlsystem (nicht gezeichnet) verbunden.

Die Durchflussgeschwindigkeit der Kühlflüssigkeit wählt man in der Kühlzone bei manchen Ausführungsformen für eine effiziente Kühlung so hoch, dass eine turbulente Strömung, und dadurch eine gute Durchmischung der Kühlflüssigkeit auftritt. Dazu muss die so genannte Kritische Reynoldszahl von 2320 überschritten werden. Für Wasser als Kühlflüssigkeit und bei einem Kühlrohr-Innendurchmesser von 5mm muss dafür die Durchflussgeschwindigkeit beispielsweise größer als 0.5m/s bei 20°C sein. In den übrigen Zonen, wie bspw. bei den Schläuchen und Anschlüssen, wählt man hingegen größere Querschnitte, um bei einer laminaren Strömung geringere Strömungsverlusten zu erzielen.

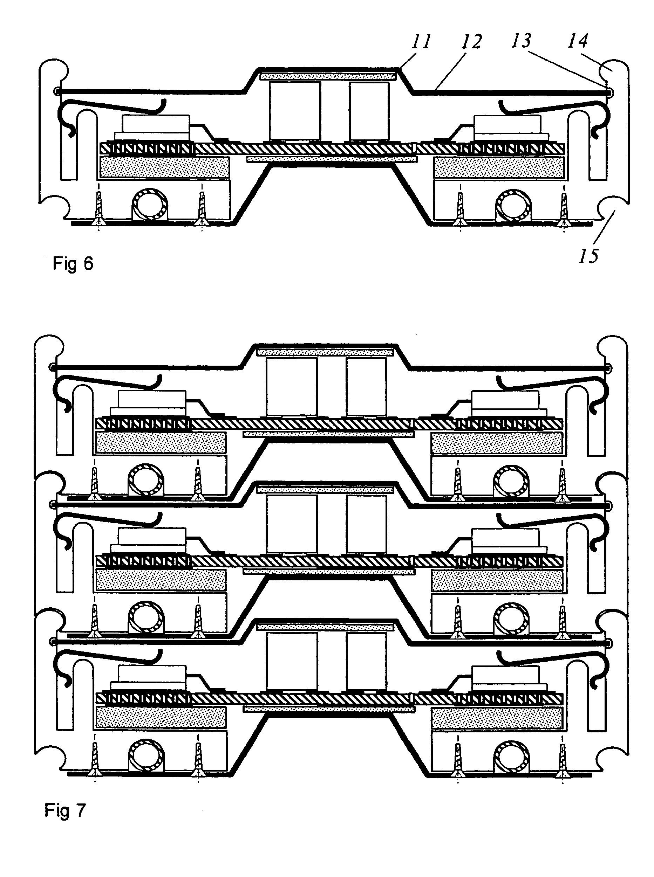

Ausführungsformen nach den folgenden Fig. 6 bis Fig. 21 können, wie auch die Ausführungsform nach Fig. 5, beliebig mit ungefilterter Kühlluft und/oder einer Kühlflüssigkeit gekühlt werden. In Erosionsmaschinen sind meistens schon Einrichtungen für Flüssigkeitskühlung vorhanden, um die Dielektrika auf konstanter Temperatur zu halten. Folglich kann es bei manchen Ausführungsformen preisgünstig sein, diese etwas größer auszulegen, um auch die Elektronikmodule zu kühlen. Bei manchen Ausführungsformen zirkuliert die Kühlflüssigkeit der Kühleinrichtung oder auch das gekühlte Dielektrikum der Erosionsmaschine über die Module direkt.

Beim direkten Einbau in eine Maschine, wird bei manchen Ausführungsformen bei der Luftkühlung darauf geachtet, dass die erhitzte Abluft nicht mit der Maschinenstruktur in Kontakt kommt, sondern über eine kaminförmige Einrichtung nach oben abgegeben wird. Bei stark verschmutzter Kühlluft werden die Kühlflächen der Module bei manchen Ausführungsformen regelmäßig gereinigt, um die Kühlwirkung zu garantieren. Dies ist für viele Anwender billiger und einfacher, als Luftfilter auszutauschen.

Die Kombination von Luftkühlung und Flüssigkeitskühlung kann in tropischen Ländern besonders vorteilhaft sein, wo die Umgebungstemperatur in den Werkstätten nicht selten 45°C übersteigt. Mit einer geringen zusätzlichen Flüssigkeitskühlung kann eine solche Maschine, die normalerweise abgeschaltet werden müsste, nun mit voller Leistung weiter produzieren.

Fig. 6 zeigt eine weitere Ausführungsform, bei der ein Deckblech 12 die Module gegen Umwelteinflüsse abschirmt und eine Art Verzahnung, die durch konvexe Ausbildungen 14 und konkave Ausbildungen 15 der Kühlkörperprofile 4 gebildet ist, die Module stapelbar macht. Die Module können, so wie in Fig. 7 dargestellt, ineinander geschoben oder eingerastet werden. Stirnseitig, beidseitig angebrachte Deckbleche (nicht gezeichnet) oder Abschlüsse (nicht gezeichnet) verleihen den Modulen einen geschützten Innenraum und eine gute mechanische Stabilität.

Das Deckblech 12 kann zusätzlich über zweite Wärmeleitfolien 11 Abwärme von der Oberseite von SMD-Bauelementen abführen. Das Deckblech 12 steht dafür über eine Einkerbung 13 in thermischem Kontakt mit den Kühlkörperprofilen 4. Auch hier wird die Elastizität des Deckbleches 12 für einen dauerhaft geringen thermischen Übergangswiderstand ausgenützt.

Bei manchen Ausführungsformen, bei welchen die Deckbleche 12 keine Wärme ableiten müssen, können diese in Systemen wie nach Fig. 7, mit Ausnahme des obersten Moduls, weggelassen werden.

Um hohe Verlustleistungen abführen zu können, wird bei manchen Ausführungsformen die Leiterplatte 2 dünn ausgeführt, weil die Temperaturdifferenz zwischen SMD-Leistungselement 1 und Keramikisolation 3 proportional zur Leiterplattendicke ansteigt. Dies hat aber als Konsequenz, dass die mechanische Stabilität der Leiterplatte 2 bei manchen Ausführungsformen ungenügend werden kann.

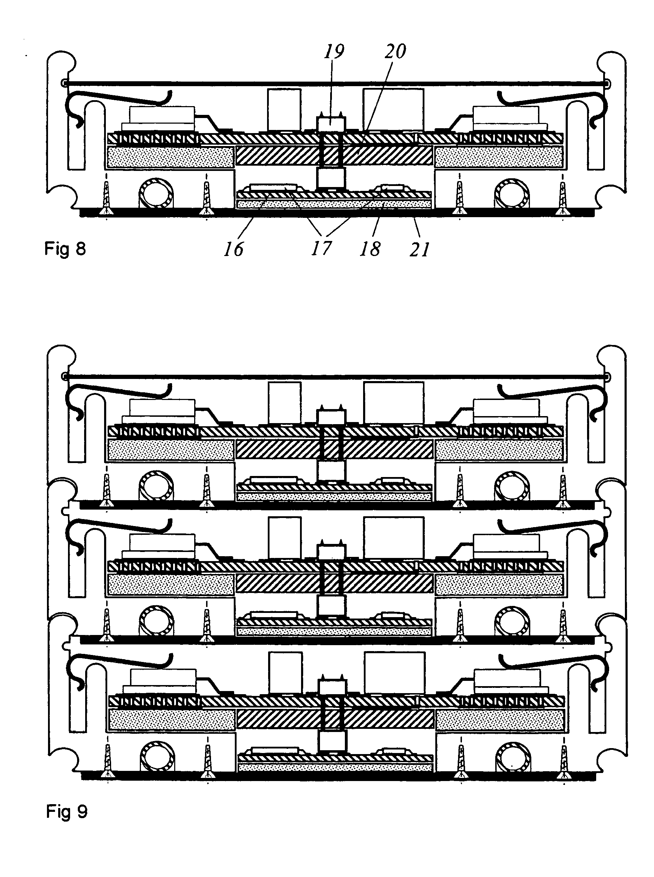

Die in Fig. 8 dargestellte Ausführungsform weist daher eine Verstärkungsplatte 20 auf der Rückseite (auf der Seite ohne SMD- Bauelemente) der Leiterplatte 2 auf.

Die Verstärkungsplatte 20 kann zusammen mit den Keramikisolationen 3 über so genannte Prepregs mit der Leiterplatte 2 vereint werden. Dieses Verfahren ist bekannt, und z.B. in der Patentanmeldung EP 06 02 2498 eingehend beschrieben.

Alternativ wird die Leiterplatte 2 mit der Verstärkungsplatte 20 und den Keramikisolationen 3 bei manchen Ausführungsformen auch verlötet, was besonders geringe Wärmeübergangswiderstände ergibt. Dazu müssen sowohl die Verstärkungsplatte 20 als auch die Keramikisolationen 3 an geeigneten Stellen eine Kupferbeschichtung aufweisen. Kupferbeschichtete Keramikisolationen 3 können ebenfalls von der erwähnten Firma DENKA, oder von der Firma CURAMIK ELECTRONICS (www.curamik.com) bezogen werden.

Bei einigen der bisher beschriebenen Ausführungsformen wird nur eine Leiterplatte 2 pro Modul benötigt. Dies verlangt aber nach Kompromissen und ist daher für Hochleistungs-Anwendungen weniger geeignet.

Die Ausführungsform nach Fig. 8 zeigt darum weiter, wie man die SMD-Steuerelemente 17 von der Leiterplatte 2 auf eine Steuerplatte 16 auslagern kann. Dazu werden die Leiterplatte 2 und die Steuerplatte 16 an geeigneten Stellen mit SMD-Steckverbindern 19 verbunden. In diesem Fall genügen für die Leiterplatte 2 meistens zwei Leiterebenen mit Hochstrom-Leiterbahnen, welche mit Durchkontaktierungen verbunden sein können. Hochstrom-Leiterbahnen decken typisch einen Bereich von 5 Ampere bis 200 Ampere ab, und werden bei manchen Ausführungsformen in Leiterdicken auch bis über 200µm ausgeführt.

Die Steuerplatte 16 kann hingegen bei manchen Ausführungsformen mit beliebig vielen Leiterebenen und in Feinleitertechnik ausgeführt werden, da hier keine großen thermischen Probleme oder hohe Ströme vorliegen. Die Steuerplatte 16 kann über eine selbstklebende Wärmeleitfolie 18 mit einem verstärkten Bodenblech 21 verbunden werden. Das verstärkte Bodenblech 21 leitet dann die Wärme auf die Kühlkörperprofile 4 ab.

Für die selbstklebende Wärmeleitfolien 18 kann beispielsweise das Produkt THERMATTACH T413 der Firma CHOMERICS (www.chomerics.com) verwendet werden. Dieses Material hat einen thermischen Leitwert von nur 0.35W/mK, was in diesem Fall aber ausreichend ist. Bei einer Reparatur kann diese Klebeverbindung mit einem Spachtel gelöst werden, muss jedoch bei einer erneuten Montage bei manchen Ausführungsformen nach der Reinigung der Klebeflächen durch eine neue Folie ersetzt werden.

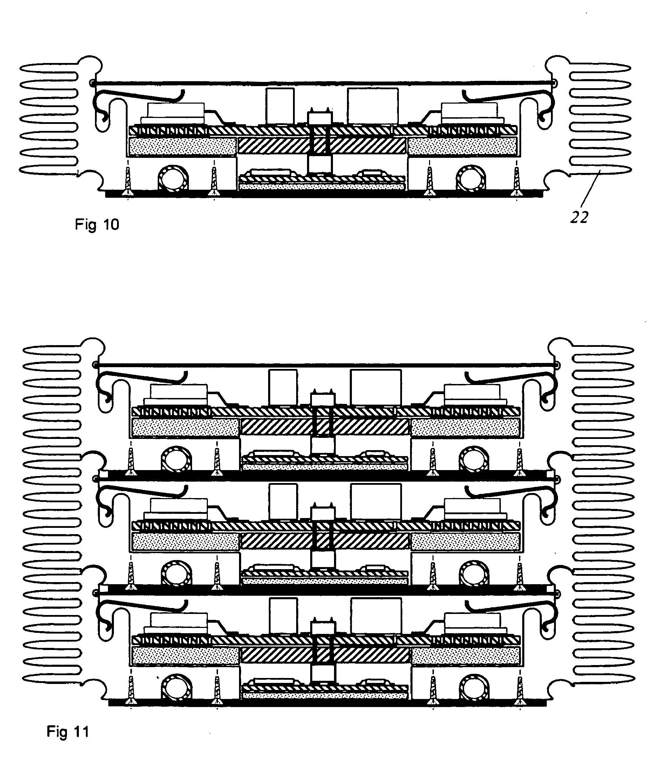

Fig. 10 zeigt eine modifizierte Ausführungsform eines Moduls nach Fig. 8, mit dem Ziel die Kühlleistung für die Luftkühlung zu erhöhen. Die Kühlkörperprofile 4 sind dafür mit zusätzlichen Kühlrippen 22 versehen. Die dadurch vergrößerte Oberfläche reduziert den Wärmeübergangs-Widerstand zwischen Kühlkörperprofil 4 und Kühlluft.

Fig. 11 zeigt beispielhaft eine Ausführungsform eines System-Pakets aus solchen Modulen. Soll die Kühlung ausschließlich über Kühlluft erfolgen, ist es bei manchen Ausführungsformen vorteilhaft die U-förmigen Kanäle 9 und die Kühlrohre 10 wegzulassen.

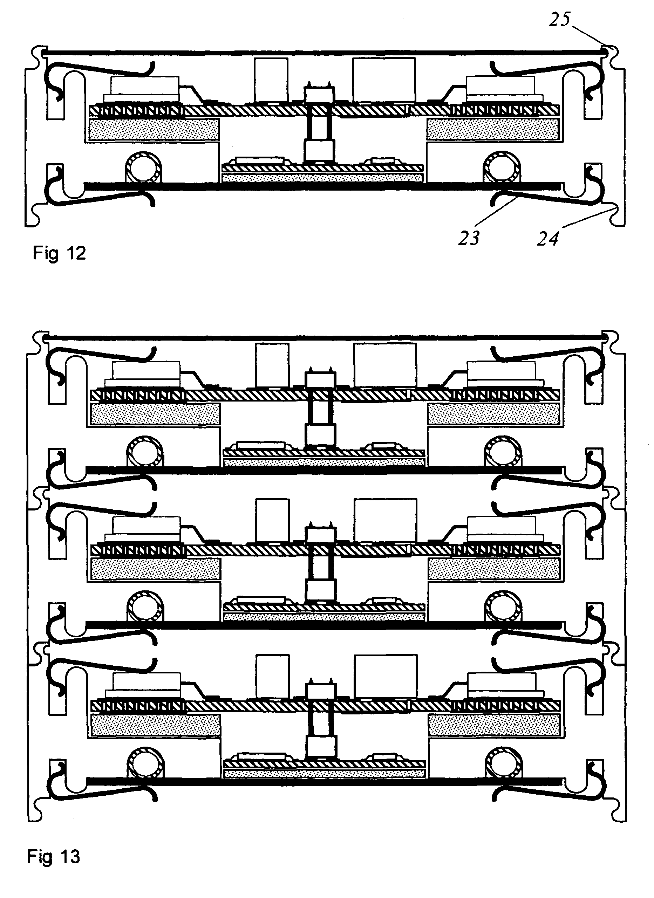

Fig. 12 zeigt eine weitere Ausführungsform der Erfindung. Zur Erleichterung der Montage und Demontage des Moduls, sind die Schrauben 8 ebenfalls durch Clips 23 ersetzt, welche identisch zu den Clips 5 für die SMD-Leistungselemente 1 bei manchen Ausführungsformen sind. Dadurch ergibt sich eine erhöhte Toleranz für Wärmedehnungen, da die Clips 23 elastischer sind als Schraubverbindungen und entsprechend eine Verlängerung der Lebensdauer des Moduls bewirken können.

Die Verzahnung der Module ist mit positiven Ausformungen 24 und dazu negativen Ausformungen 25 der Kühlkörperprofile 4 hier so modifiziert, dass Platz für die Aufnahme der Clips 23 vorhanden ist und die Bauhöhe der Module niedrig gehalten werden kann.

Fig. 13 zeigt anhand eines System-Pakets aus den Modulen nach Fig. 12, wie die Ausformungen 24 und 25 ineinandergreifen und eine entsprechende Wärmeleitung von einem Modul zum Nächsten ermöglichen.

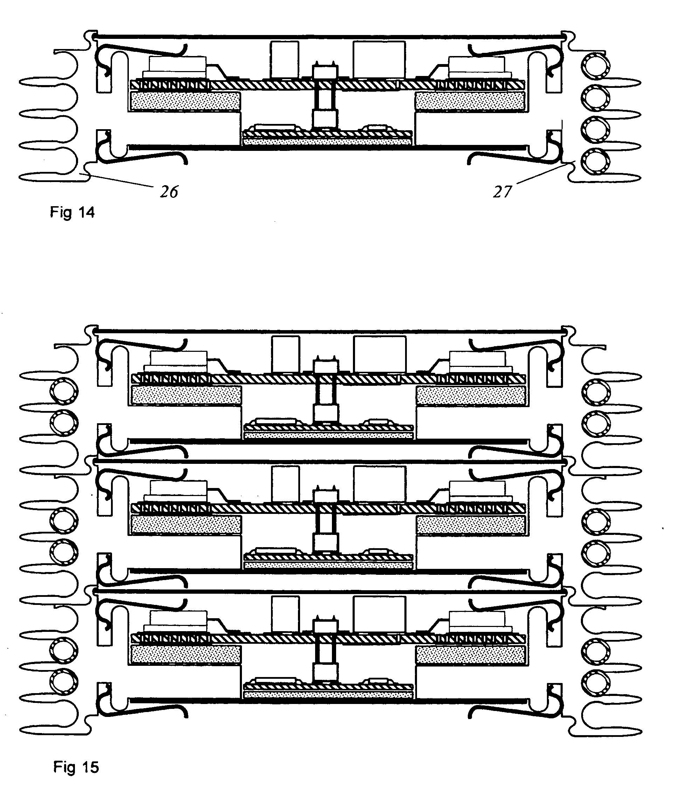

Fig. 14 zeigt eine Ausführungsform, die einen weiteren Schritt in Richtung Flexibilität für die Anwendung der Module macht. Sofern man gleiche Kühlkörperprofile 4 für Flüssigkeits- oder Luftkühlung verwenden möchte, stören im Falle ausschließlicher Luftkühlung die U-förmigen Kanäle 9 nach den Fig. 5 bis 13 den Wärmefluss zwischen den SMD- Leistungselementen 1 und der Kühlfläche für die Luftkühlung. Um diesen Nachteil zu beseitigen, werden in dieser Ausführungsform die Sitze der Kühlrohre 10 zwischen die Kühlrippen verlegt. Die Sitze sind so geformt und dimensioniert, dass die Kühlrohre 10 rein durch ihre elastische Deformation infolge Einpressens - also hier ohne zusätzliche Hilfsmittel - festsitzen. Fig. 14 zeigt beispielhaft das Kühlprofil 26 ohne Kühlrohre 10 (bei ausschließlicher Luftkühlung), und das identische Kühlprofil 27 mit Kühlrohren 10 (für Flüssigkeits- und / oder Luftkühlung).

Fig. 15 zeigt am Beispiel einer Ausführungsform eines System-Paketes, dass je nach Anforderung die Kühlrohre 10 auch nur teilweise eingesetzt werden können. Durch die Anzahl der Kühlrohre kann die Kühlleistung entsprechend modifiziert werden.

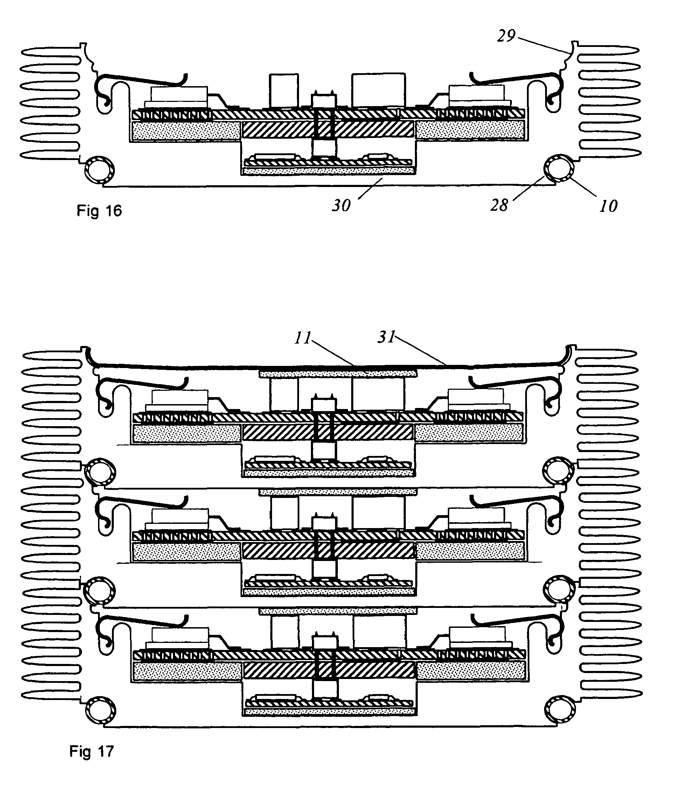

Fig. 16 zeigt ein weitere Ausführungsform für denselben Zweck. Hier sind die Kühlrohre 10 in den Bereichen angebracht, wo teilweise bei den vorhergehenden Ausführungsformen die Verzahnungen für die Stapelung der Module waren. Auf der Unterseite des Kühlkörperprofils 4 ist ein erster Kanal 28 vorgesehen, welcher so gestaltet ist, dass die Kühlrohre 10 wie nach Fig. 14 ohne zusätzliche Hilfsmittel nach dem Einpressen festsitzen. Auf der Oberseite ist ein zweiter Kanal 29 vorgesehen, welcher so ausgebildet ist, dass die Kühlrohre 10 des zu stapelnden Moduls zusätzlich elastisch verformt werden, um die Module zusammenzuhalten und um einen guten Wärmeübergang zwischen den Kühlrohren 10 und beiden gestapelten Modulen zu garantieren. Um die seitlichen Kräfte infolge der Deformation der Kühlrohre 10 besser aufnehmen zu können, wird bei dieser Ausführungsform bevorzugt ein einteiliger Kühlkörper 30 verwendet.

Zur Stapelung der Module kann man diese vertikal zusammenpressen, und einrasten lassen, oder längs zusammenschieben, wobei man die Kanäle 29 in diesem Fall auch mit einer größeren Umfassung ausbilden kann.

Als dritte Möglichkeit kann man bei manchen Ausführungsformen die Kühlrohre 10 in Längsrichtung einpressen, um Module zu vereinen, wodurch sich eine besonders robuste und wärmeleitende Verbindung ergibt. Allerdings wird die Demontage etwas aufwändiger.

Fig. 17 zeigt wie mit diesen Modulen ein System-Paket gebildet werden kann. Als Vorteile ergeben sich für dieses Beispiel, dass der Wärmefluss bei ausschließlicher Luftkühlung nicht gestört wird und dass bei Flüssigkeitskühlung ein sehr zuverlässiger Wärmekontakt der Kühlrohre 10 mit den Kühlkörperprofilen 30 entsteht. Über die Unterseite des einteiligen Kühlkörpers 30 können über zweite Wärmeleitfolien 11 SMD-Bauelemente eines darunter liegenden Moduls gekühlt werden. Das oberste Modul weist zur Abdichtung ein wärmeleitendes Deckblech 31 auf.

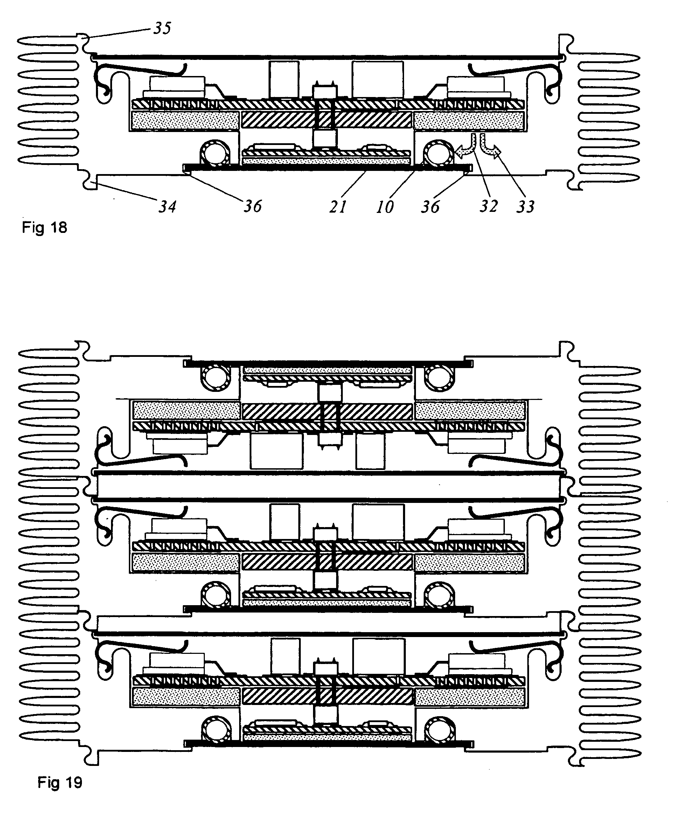

Die Ausführungsform der Fig. 18 zeigt, wie durch eine Verlagerung der Kühlrohre 10 gegen den Innenbereich des Moduls der Wärmefluss verbessert werden kann. Der Wärmefluss 32 gegen die Kühlrohre 10 ist hier vom Wärmefluss 33 gegen die Kühlrippen 22 größtenteils entkoppelt, womit alle Kühlkombinationen mit den gleichen Kühlprofilen realisiert werden können.

Als alternative Ausführungsform ist auch gezeigt, wie das verstärkte Bodenblech 21 über Aufnahmen 36 befestigt werden kann und wie auf die Kühlrohre 10 damit zusätzlicher, elastischer Druck ausgeübt werden kann.

Weiter sind in Fig. 18 eine negative Ausformung 34 und eine positive Ausformung 35 zur alternativen Stapelung der Module dargestellt, welche im Vergleich zu Fig. 12 invertiert sind. Dies gestattet es, die Module beliebig, insbesondere auch kopfüber zu stapeln.

Fig. 19 zeigt ein System-Paket nach diesem Prinzip. Das oberste Modul ist kopfüber angeordnet, womit ein Deckblech 31 eingespart werden kann. Die vorstehenden Ausformungen 34, 35 können zusätzlich zur stehenden oder hängenden Montage des System-Paketes dienen. Es genügt, nach dem seitlichem Einschieben einen einfachen Verriegelungsmechanismus zu aktivieren, um so sicheren Halt zu garantieren. Die Montage und Wartung der Module wird dadurch erheblich vereinfacht.

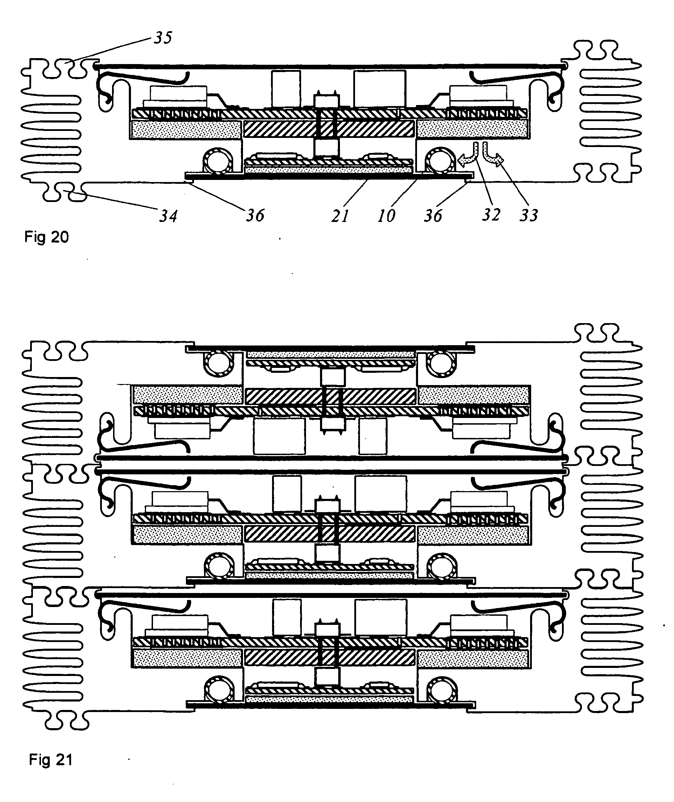

Fig. 20 zeigt eine Ausführungsform, die ähnlich zu der von Fig. 18 ist, mit dem Unterschied, dass durch die modifizierten Ausformungen 34, 35 der Wärmeübergang zu von einem Modul zu einem nächsten verbessert wird. Dies ist insbesondere in Fig. 21 zu sehen. Die Ausformungen 34, 35 sind so gestaltet, dass sie wie Puzzleteile ineinandergreifen und dadurch einen guten Wärmekontakt von einem Modul zum Nächsten ermöglichen. Dadurch ist auch eine verbesserte Kühlleistung gegeben, insbesondere bei ungleicher thermischer Belastung der Module und entsprechender Luftkühlung. Durch die Ausgestaltung der Ausformungen 34, 35 ist im Gegensatz zur Ausführungsform nach Fig. 18 und 19 ein seitliches Einschieben der einzelnen Module nicht mehr möglich.

System- Pakete nach dem Einrastverfahren können problemlos Transportschläge und Vibrationen ertragen, da die stirnseitigen Abdeckungen zusätzliche Festigkeit verleihen und dadurch ein Ausrasten zuverlässig verhindern.

Es folgen einige allgemeinere Erläuterungen zu Merkmalen der oben beschriebenen Ausführungsformen, die beliebig miteinander kombiniert werden können:

Bei manchen Ausführungsformen, die ein Verfahren zur Herstellung einer Leiterplatteneinheit betreffen, wird der Kühlkörper (4) mit einem zur Luftkühlung geeigneten Profil (22) versehen wird.

Bei manchen Ausführungsformen, die ein Verfahren zur Herstellung einer Leiterplatteneinheit betreffen, wird die Leiterplatte (2) in einer Stärke von weniger als 2mm, bevorzugt weniger als 1 mm ausgeführt wird, und die Leiterplatte wird aus Glasfaser-Epoxydharz-Material oder aus einem pulvergefüllten Polymer hergestellt.

Bei manchen Ausführungsformen, die ein Verfahren zur Herstellung einer Leiterplatteneinheit betreffen, wird die thermisch leitende und elektrisch isolierende Schicht (3) aus einer thermisch leitenden und elektrisch isolierenden Keramik, insbesondere aus Aluminiumoxid (Al2O3) oder Aluminiumnitrid (AIN), hergestellt.

Bei manchen Ausführungsformen, die ein Verfahren zur Herstellung einer Leiterplatteneinheit betreffen, wird die Leiterplatte (2) durch eine Verstärkungsplatte (20) aus Glasfaser-Epoxydharz-Material oder einem pulvergefüllten Polymer gestützt.

Bei manchen Ausführungsformen, die ein Verfahren zur Herstellung einer Leiterplatteneinheit betreffen, werden äußere Bereiche der Kühlkörper (4) mit Kühlrippen (22) versehen und zwischen den Kühlrippen (22) werden dünnwandige Kühlrohre unter elastischer Deformation der Kühlrohre eingepresst und die Abfuhr der Wärme wird über ungefilterte Kühlluft und/oder eine Kühlflüssigkeit, die durch die Kühlrohre fließt, vorgesehen.

Bei manchen Ausführungsformen, die ein Verfahren zur Herstellung einer Leiterplatteneinheit betreffen, werden die Kühlkörper (4) in Abhängigkeit der abzuleitenden Wärmemenge ausgestaltet und die Abfuhr der Wärme nur durch Kühlflüssigkeit oder nur durch Kühlluft oder durch eine Kombination aus Kühlflüssigkeit und Kühlluft bewirkt.

Bei manchen Ausführungsformen, die ein Verfahren zur Herstellung einer Leiterplatteneinheit betreffen, werden auf einer Außenseite der Kühlkörper Einkerbungen (13) zur Aufnahme eines Deckbleches (12) vorgesehen.

Bei manchen Ausführungsformen, die ein Verfahren zur Herstellung einer Leiterplatteneinheit betreffen, wird die thermisch leitende und elektrisch isolierende Schicht (3) und eine Verstärkungsplatte (20) leiterplattenseitig mit Kupfer beschichtet und die thermisch leitende und elektrisch isolierende Schicht (3) und die Verstärkungsplatte (20) werden mit der Leiterplatte (2) verlötet.

Bei manchen Ausführungsformen, die ein Verfahren zur Herstellung einer Leiterplatteneinheit betreffen, werden die thermisch leitenden und elektrisch isolierende Schicht (3) und die Verstärkungsplatte (20) während des Leiterplatten-Fertigungsprozesses mit der Leiterplatte (2) durch Polymerisation verbunden werden.

Bei manchen Ausführungsformen, die ein Verfahren zur Herstellung einer Leiterplatteneinheit betreffen, wird zusätzlich zur Leiterplatte (2) eine Steuerplatte (16) mit oberflächenmontierbaren Steuerelementen (17) angeordnet und die Steuerplatte (16) über eine selbstklebende Wärmeleitfolie (18) mit einem Bodenblech (21) verbunden und von diesem gekühlt und die Steuerplatte (16) wird über oberflächenmontierbare Steckverbinder (19) elektrisch mit der Leiterplatte (2) verbunden.

Bei manchen Ausführungsformen einer Leiterplatteneinheit weist der Kühlkörper (4) ein zur Luftkühlung geeignetes Profil (22) auf.

Bei manchen Ausführungsformen einer Leiterplatteneinheit weisen äußere Bereiche der Kühlkörper Kühlrippen (22) auf und zwischen den Kühlrippen sind bspw. dünnwandige Kühlrohre unter elastischer Deformation eingepresst und die Abfuhr der Wärme ist über ungefilterte Kühlluft und/oder eine Kühlflüssigkeit vorgesehen.

Bei manchen Ausführungsformen einer Leiterplatteneinheit wird die Leiterplatte zusätzlich durch eine Verstärkungsplatte (20) aus Glasfaser-Epoxydharz-Material oder aus einem pulvergefüllten Polymer gestützt und die thermisch leitende und elektrisch isolierende Schicht (3) und die Verstärkungsplatte (20) weisen leiterplattenseitig jeweils eine Kupferbeschichtung auf und die thermisch leitende und elektrisch isolierende Schicht (3) und die Verstärkungsplatte (20) sind bspw. mit der Leiterplatte (2) verlötet.

Bei manchen Ausführungsformen sind die thermisch leitende und elektrisch isolierende Schicht (3) und die Verstärkungsplatte (20) mit der Leiterplatte durch Polymerisation zu einer Einheit verbunden.

Bei manchen Ausführungsformen einer Leiterplatteneinheit weist diese zusätzlich zur Leiterplatte (2) mit Leistungselementen (1) eine Steuerplatte (16) auf, welche oberflächenmontierbare Steuerelemente (17) aufweist. Beispielsweise ist die Steuerplatte (16) über eine selbstklebende Wärmeleitfolie (18) mit einem Blech (21) verbunden, so dass sie von diesem gekühlt wird, und die Steuerplatte (16) ist über oberflächenmontierbare Steckverbinder (19) elektrisch mit der Leiterplatte (2) verbunden.

Bei manchen Ausführungsformen einer Leiterplatteneinheit ist der Kühlkörper in Abhängigkeit der abzuleitenden Wärmemenge ausgestaltet und die Abfuhr der Wärme wird bspw. nur durch Kühlflüssigkeit oder nur durch Kühlluft oder durch eine Kombination aus Kühlflüssigkeit und Kühlluft bewirkt.

Viele weitere Ausführungsformen und Kombinationen der vorliegenden Erfindung sind möglich. Der Fachmann kann bspw. beliebig Formen von Verzahnungen für die Stapelung, oder Höhen, Breiten und Längen der Module festlegen, sowie eine beliebige Anzahl von Kühlkörperprofilen 4 und Leiterplatten 2 pro Modul für seine speziellen Zwecke auswählen.

Die angeführten Beispiele dienen nur zum besseren Verständnis. Illustrative Angaben wie: oben, unten, negativ, positiv, seitlich, Bodenblech oder Deckblech sind nicht einschränkend zu verstehen.

## Patentansprüche

1. Verfahren zur Herstellung einer Leiterplatteneinheit, bei dem:
- oberflächenmontierbare Bauelemente (1, 17) auf einer Leiterplatte (2) automatisch platziert und gelötet werden,
- thermisch belastete oberflächenmontierbare Leistungselemente (1) auf der Leiterplatte (2) in Wärmeleitungsbereichen angeordnet werden, in denen metallische Durchkontaktierungen zur Wärmeleitung angeordnet werden,
- zwischen den oberflächenmontierbaren Leistungselementen (1) und einem oder mehreren Kühlkörpern (4) im Bereich der Durchkontaktierungen eine thermisch leitende und elektrisch isolierende Schicht (3) angeordnet wird, **dadurch gekennzeichnet, dass** die oberflächenmontierbaren Leistungselemente (1) mit wenigstens einem elastischen Clip (5) über die zwischenliegende Leiterplatte (2) derart gegen den oder die mehreren Kühlkörper (4) angepresst werden, dass die von den oberflächenmontierbaren Leistungselementen (1) erzeugte Wärme über die Durchkontaktierungen zu den Kühlkörpern abgeleitet wird.

2. Verfahren nach Anspruch 1, bei dem der Kühlkörper (4) mit einem Aufnahmebereich versehen wird, in dem ein Ende des Clips angeordnet wird, während das andere Ende des Clips einen Anpressdruck auf das und/oder die oberflächenmontierbaren Leistungselemente (1) ausübt.

3. Verfahren nach Anspruch 1 oder 2, bei dem die Wärme von den Kühlkörpern (4) über ein gasförmiges und/oder flüssiges Kühlmedium abgeleitet wird.

4. Verfahren nach einem der vorhergehenden Ansprüche, bei dem zur Flüssigkeitskühlung die Kühlkörper (4) mit einem oder mehreren Kanälen (9) versehen werden und in diesen Kanälen Kühlrohre (10) angeordnet werden.

5. Verfahren nach Anspruch 4, bei dem die Kühlrohre (10) in die Kanäle (9) eingepresst werden und die Kühlrohre (10) so dünnwandig ausgelegt werden, dass sie sich durch elastische Deformation den Kanälen (9) anpassen.

6. Verfahren nach einem der vorhergehenden Ansprüche, bei dem die Kühlkörper so ausgebildet werden, dass sie an der Unterseite elastische Clips (23) aufnehmen können, um die Kühlrohre (10) in die Kanäle einzupressen.

7. Verfahren nach einem der vorhergehenden Ansprüche, bei dem oberflächenmontierbare Steuerelemente (17) auf der Leiterplatte (2) angeordnet werden und eine erste Wärmeleitfolie (6) und ein Bodenblech (7) derart angeordnet werden, dass sie Wärme von den Steuerelementen (17) ableiten.

8. Verfahren nach einem der vorhergehenden Ansprüche, bei dem ein Deckblech (12) und eine zweite Wärmeleitfolie (11) derart angeordnet werden, dass Wärme von der Oberseite der oberflächenmontierbaren Bauelemente (17) abgeleitet wird und bei dem die Leiterplatteneinheit stirnseitig durch Abdeckungen beidseitig dicht verschlossen werden.

9. Verfahren nach einem der vorhergehenden Ansprüche, bei dem zur Stapelung von mehreren Leiterplatteneinheiten an Außenpartien der Kühlkörper (4) positive und dazu entsprechende negative Ausformungen (14, 15; 24, 25; 34, 35) vorgesehen werden, sodass mehrere Leiterplatteneinheiten an den Ausformungen ineinander greifend verbunden werden können.

10. Leiterplatteneinheit, umfassend:
- eine Leiterplatte (2) mit darauf gelöteten oberflächenmontierbaren Bauelementen (1, 17),
- wenigstens ein auf der Leiterplatte (2) in Wärmeleitungsbereichen angeordnetes thermisch belastetes oberflächenmontierbares Leistungselement (1), wobei die Wärmeleitungsbereiche metallische Durchkontaktierungen zur Wärmeleitung aufweisen,
- eine thermisch leitende und elektrisch isolierende Schicht (3), die zwischen den oberflächenmontierbaren Leistungselementen (1) und einem oder mehreren Kühlkörpern (4) im Bereich der Durchkontaktierungen angeordnet ist, **dadurch gekennzeichnet, dass** die oberflächenmontierbaren Leistungselemente mit wenigstens einem elastischen Clip (5) über die zwischenliegende Leiterplatte (2) derart gegen den oder die mehreren Kühlkörper (4) angepresst werden, dass die von den oberflächenmontierbaren Leistungselementen (1) erzeugte Wärme über die Durchkontaktierungen zu den Kühlkörpern (4) abgeleitet wird.

11. Leiterplatteneinheit nach Anspruch 10, bei dem der Kühlkörper (4) einen Aufnahmebereich aufweist, in dem ein Ende des Clips angeordnet wird, während das andere Ende des Clips einen Anpressdruck auf das und/oder die oberflächenmontierbaren Leistungselemente (1) ausübt.

12. Leiterplatteneinheit nach Anspruch 10 oder 11, bei der die Wärme von dem oder den Kühlkörpern (4) über ein gasförmiges und/oder flüssiges Kühlmedium abgeleitet wird.

13. Leiterplatteneinheit nach einem der Ansprüche 10 bis 12, bei der die Leiterplatte (2) eine Stärke von weniger als 2mm, bevorzugt weniger als 1 mm, aufweist und die Leiterplatte Glasfaser-Epoxydharz-Material oder ein gefülltes Polymer aufweist.

14. Leiterplatteneinheit nach einem der Ansprüche 10 bis 13, bei der die thermisch leitende und elektrisch isolierende Schicht (3) eine Keramik, insbesondere aus Aluminiumoxid (Al₂O₃) oder Aluminiumnitrid (AIN) aufweist.

15. Leiterplatteneinheit nach einem der Ansprüche 10 bis 14, bei der die Kühlkörper (4) einen oder mehrere Kanäle (9) zur Flüssigkeitskühlung aufweisen und Kühlrohre (10) in den Kanälen (9) angeordnet sind, wobei die Kühlrohre so dünnwandig sind, dass sie durch elastische Deformation den Kanälen angepasst sind.

16. Leiterplatteneinheit nach einem der Ansprüche 10 bis 15, bei der die Kühlkörper so ausgebildet sind, dass sie elastische Clips (23) so aufnehmen können, dass die Kühlrohre in die Kanäle der Kühlkörper eingepresst werden.

17. Leiterplatteneinheit nach einem der Ansprüche 10 bis 16, bei der Außenbereiche der Kühlkörper (4) positive und entsprechende negative Ausformungen (14, 15; 24, 25; 34, 35) zur Stapelung von mehreren Leiterplatteneinheit aufweisen, sodass mehrere Leiterplatteneinheiten an den Ausformungen ineinander greifend verbunden werden können.

## Claims

1. Method for producing a printed circuit board unit, in which:
- surface-mountable components (1, 17) are automatically placed on a printed circuit board (2) and soldered,
- thermally loaded surface-mountable power elements (1) are arranged on the printed circuit board (2) in heat conducting regions, in which metallic plated-through holes are arranged for heat conduction,
- a thermally conducting and electrically insulating layer (3) is arranged between the surface-mountable power elements (1) and one or more heat sinks (4) in the region of the plated-through holes, **characterized in that** the surface-mountable power elements (1) are pressed by at least one elastic clip (5) via the printed circuit board (2) lying in between against the one or more heat sinks (4) in such a way that the heat generated by the surface-mountable power elements (1) is dissipated by way of the plated-through holes to the heat sinks.

2. Method according to Claim 1, in which the heat sink (4) is provided with a receiving region, in which one end of the clip is arranged, while the other end of the clip exerts a pressing pressure on the surface-mountable power element and/or elements (1).

3. Method according to Claim 1 or 2, in which the heat from the heat sinks (4) is dissipated by way of a gaseous and/or liquid cooling medium.

4. Method according to one of the preceding claims, in which the heat sinks (4) are provided with one or more channels (9) for liquid cooling and cooling tubes (10) are arranged in these channels.

5. Method according to Claim 4, in which the cooling tubes (10) are pressed into the channels (9) and the cooling tubes (10) are designed with such thin walls that they adapt to the channels (9) by elastic deformation.

6. Method according to one of the preceding claims, in which the heat sinks are formed such that they can receive elastic clips (23) on the underside in order to press the cooling tubes (10) into the channels.

7. Method according to one of the preceding claims, in which surface-mountable control elements (17) are arranged on the printed circuit board (2) and a first heat conducting foil (6) and a bottom plate (7) are arranged in such a way that they dissipate heat from the control elements (17).

8. Method according to one of the preceding claims, in which a top plate (12) and a second heat conducting foil (11) are arranged in such a way that heat is dissipated from the upper side of the surface-mountable components (17) and in which the printed circuit board unit is sealed at the ends on both sides by coverings.

9. Method according to one of the preceding claims, in which positive and matching negative formations (14, 15; 24, 25; 34, 35) are provided on outer portions of the heat sinks (4) for the stacking of multiple printed circuit board units, so that multiple printed circuit board units can be connected by engaging in one another at the formations.

10. Printed circuit board unit, comprising:
- a printed circuit board (2) with surface-mountable components (1, 17) soldered thereon,
- at least one thermally loaded surface-mountable power element (1) arranged on the printed circuit board (2) in heat conducting regions, the heat conducting regions having metallic plated-through holes for heat conduction,
- a thermally conducting and electrically insulating layer (3), which is arranged between the surface-mountable power elements (1) and one or more heat sinks (4) in the region of the plated-through holes, **characterized in that** the surface-mountable power elements are pressed by at least one elastic clip (5) via the printed circuit board (2) lying in between against the one or more heat sinks (4) in such a way that the heat generated by the surface-mountable power elements (1) is dissipated by way of the plated-through holes to the heat sinks (4).

11. Printed circuit board unit according to Claim 10, in which the heat sink (4) has a receiving region, in which one end of the clip is arranged, while the other end of the clip exerts a pressing pressure on the surface-mountable power element and/or elements (1).

12. Printed circuit board unit according to Claim 10 or 11, in which the heat from the heat sink or sinks (4) is dissipated by way of a gaseous and/or liquid cooling medium.

13. Printed circuit board unit according to one of Claims 10 to 12, in which the printed circuit board (2) has a thickness of less than 2 mm, preferably less than 1 mm, and the printed circuit board comprises glass-fibre/epoxy-resin material or a filled polymer.

14. Printed circuit board unit according to one of Claims 10 to 13, in which the thermally conducting and electrically insulating layer (3) comprises a ceramic, in particular of aluminium oxide (Al₂O₃) or aluminium nitride (AlN).

15. Printed circuit board unit according to one of Claims 10 to 14, in which the heat sinks (4) have one or more channels (9) for liquid cooling and cooling tubes (10) are arranged in the channels (9), the cooling tubes having such thin walls that they are adapted to the channels by elastic deformation.

16. Printed circuit board unit according to one of Claims 10 to 15, in which the heat sinks are formed such that they can receive elastic clips (23) such that the cooling tubes are pressed into the channels of the heat sinks.

17. Printed circuit board unit according to one of Claims 10 to 16, in which outer regions of the heat sinks (4) have positive and matching negative formations (14, 15; 24, 25; 34, 35) for the stacking of multiple printed circuit board units, so that multiple printed circuit board units can be connected by engaging in one another at the formations.

## Revendications

1. Procédé de fabrication d'une unité de carte de circuit, dans lequel :
des composants (1, 17) aptes à être montés en surface sont placés automatiquement sur une carte de circuit (2) et brasés,
des éléments de puissance (1) aptes à être montés en surface et sollicités thermiquement sont disposés sur la carte de circuit (2) dans des zones conductrices de chaleur traversées par des contacts métalliques permettant la conduction de chaleur,
une couche thermiquement conductrice et électriquement isolante (3) est disposée au niveau des passages de contact entre les éléments de puissance (1) aptes à être montés en surface et un ou plusieurs corps de refroidissement (4),
**caractérisé en ce que**
les éléments de puissance (1) aptes à être montés en surface sont repoussés contre le ou les différents corps de refroidissement (4) à l'aide d'au moins une pince élastique (5) et au-dessus de la carte de circuit intercalaire (2) de telle sorte que la chaleur dégagée par les éléments de puissance (1) aptes à être montés en surface soient évacués vers les corps de refroidissement par l'intermédiaire des passages de contact.

2. Procédé selon la revendication 1, dans lequel le corps de refroidissement (4) est doté d'une zone de reprise dans laquelle une extrémité de la pince est placée tandis que l'autre extrémité de la pince exerce une poussée sur le ou les éléments de puissance (1) aptes à être montés en surface.

3. Procédé selon les revendications 1 ou 2, dans lequel la chaleur est évacuée des corps de refroidissement (4) par l'intermédiaire d'un fluide de refroidissement gazeux et/ou liquide.

4. Procédé selon l'une des revendications précédentes, dans lequel les corps de refroidissement (4) sont dotés d'un ou plusieurs canaux (9) en vue de leur refroidissement par liquide, des tubes de refroidissement (10) étant disposés dans ces canaux.

5. Procédé selon la revendication 4, dans lequel les tubes de refroidissement (10) sont enfoncés dans les canaux (9) et les tubes de refroidissement (10) ont une paroi suffisamment mince pour pouvoir s'adapter aux canaux (9) par déformation élastique.

6. Procédé selon l'une des revendications précédentes, dans lequel les corps de refroidissement sont configurés de manière à pouvoir reprendre des pinces élastiques (23) sur leur côté inférieur pour repousser les tubes de refroidissement (10) dans les canaux.

7. Procédé selon l'une des revendications précédentes, dans lequel des éléments de commande (17) aptes à être montés en surface sont disposés sur la carte de circuit (2) et un film thermiquement conducteur (6) et une tôle de fond (7) sont disposés de manière à évacuer la chaleur des éléments de commande (17).

8. Procédé selon l'une des revendications précédentes, dans lequel une tôle de recouvrement (12) et un deuxième film thermiquement conducteur (11) sont disposés de telle sorte que la chaleur soit évacuée du côté supérieur des composants (17) aptes à être montés en surface et dans lequel l'unité de carte de circuit est fermée frontalement et des deux côtés de manière étanche par des recouvrements.

9. Procédé selon l'une des revendications précédentes, dans lequel des déformations positives et des déformations négatives correspondantes (14, 15; 24, 25; 34, 35) sont prévues sur des parties extérieures des corps de refroidissement (4) pour permettre l'empilement de plusieurs unités de carte de circuit de telle sorte que plusieurs unités de carte de circuit puissent être reliées les unes aux autres en s'engageant les unes dans les autres au niveau des déformations.

10. Unité de carte de circuit comprenant :
une carte de circuit (2) sur laquelle des composants (1, 17) aptes à être montés en surface sont brasés,
au moins un élément de puissance (1) apte à être monté en surface, sollicité thermiquement et disposé sur la carte de circuit (2) dans des zones de conduction de chaleur, les zones de conduction de chaleur étant traversées par des contacts métalliques permettant l'évacuation de la chaleur,
une couche (3) thermiquement conductrice et électriquement isolante disposée entre les éléments de puissance (1) aptes à être montés en surface et un ou plusieurs corps de refroidissement (4) est disposée au niveau des passages de contact,
**caractérisée en ce que**
les éléments de puissance aptes à être montés en surface sont repoussés contre le ou les différents corps de refroidissement (4) à l'aide d'au moins une pince élastique (5) située au-dessus de la carte de circuit intercalaire (2) de telle sorte que la chaleur dégagée par les éléments de puissance (1) aptes à être montés en surface soit évacuée vers les corps de refroidissement (4) par l'intermédiaire des passages de contact.

11. Unité de carte de circuit selon la revendication 10, dans laquelle le corps de refroidissement (4) présente une zone de reprise dans laquelle une extrémité de la pince est placée tandis que l'autre extrémité de la pince exerce une poussée sur le ou les éléments de puissance (1) aptes à être montés en surface.

12. Unité de carte de circuit selon les revendications 10 ou 11, dans laquelle la chaleur est évacuée des corps de refroidissement (4) par l'intermédiaire d'un fluide de refroidissement gazeux et/ou liquide.

13. Unité de carte de circuit selon l'une des revendications 10 à 12, dans laquelle la carte de circuit (2) présente une épaisseur inférieure à 2 mm, de préférence inférieure à 1 mm et dans laquelle la carte de circuit présente un matériau à base de résine époxy et de fibres de verre ou un polymère chargé.

14. Unité de carte de circuit selon l'une des revendications 10 à 13, dans laquelle la couche (3) thermiquement conductrice et électriquement isolante présente une céramique, en particulier en oxyde d'aluminium (Al₂O₃) ou en nitrure d'aluminium (ALN).

15. Unité de carte de circuit selon l'une des revendications 10 à 14, dans laquelle les corps de refroidissement (4) présentent un ou plusieurs canaux (9) permettant le refroidissement par un liquide, des tubes de refroidissement (10) étant disposés dans les canaux (9) et les tubes de refroidissement présentant une paroi suffisamment mince pour pouvoir s'adapter aux canaux par déformation élastique.

16. Unité de carte de circuit selon l'une des revendications 10 à 15, dans laquelle les corps de refroidissement sont configurés de manière à pouvoir reprendre des pinces élastiques (23) sur leur côté inférieur pour repousser les tubes de refroidissement (10) dans les canaux.

17. Unité de carte de circuit selon l'une des revendications 10 à 16, dans laquelle les parties extérieures des corps de refroidissement (4) présentent des déformations positives et négatives correspondantes (14, 15; 24, 25; 34, 35) qui permettent d'empiler plusieurs unités de carte de circuit de telle sorte que plusieurs unités de carte de circuit puissent être reliées les unes aux autres en s'engageant les unes dans les autres au niveau des déformations.
